(19) Europäisches Patentamt
European Patent Office
Office européen des brevets

(11) EP 2 711 161 A1

(12) EUROPEAN PATENT APPLICATION
published in accordance with Art. 153(4) EPC

(43) Date of publication:
26.03.2014 Bulletin 2014/13

(51) Int Cl.:
B29C 59/02 (2006.01)    B29C 33/40 (2006.01)
H01L 21/027 (2006.01)

(21) Application number: 12785578.1

(22) Date of filing: 15.05.2012

(86) International application number:
PCT/JP2012/062391

(87) International publication number:
WO 2012/157636 (22.11.2012 Gazette 2012/47)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 19.05.2011  JP 2011112187

(71) Applicant: Soken Chemical & Engineering Co.,
Ltd.
Toshima-ku
Tokyo 171-8531 (JP)

(72) Inventors:
• TAKAHASHI, Takanori
Sayama-shi, Saitama 350-1320 (JP)

• YAMADA, Hiroko
Sayama-shi, Saitama 350-1320 (JP)
• MIZAWA, Takahide
Sayama-shi, Saitama 350-1320 (JP)
• KOJIMA, Ryota
Sayama-shi, Saitama 350-1320 (JP)

(74) Representative: Hall, Matthew Benjamin
Dehns
St. Bride's House
10 Salisbury Square
London EC4Y 8JD (GB)

(54) NANOIMPRINT MOLD AND CURVED BODY

(57)     The nanoimprint mold for a curved surface of
the present invention is characterized by comprising a
silicone rubber elastic body having an Hs rubber hardness, in the case of a thickness of 250 $\mu$m, of 10 to 55
and by having fine depressions and protrusions formed
on the surface. According to the nanoimprint mold for a
curved surface of the present invention, a nanoimprint
can be formed even on a curved surface.

[Fig. 1]

EP 2 711 161 A1

**Description**

Technical Field

The present invention relates to a mold for forming depressions and protrusions of nanometer order and a curved surface body obtained by using the mold.

Background Art

For optical communication, a demultiplexing spectroscopic device has been used. In such a demultiplexing spectroscopic device, a wavelength spectroscopic device to disperse a necessary wavelength is used. In many cases, the demultiplexing spectroscopic device is formed on a flat surface of a transparent substrate, but the demultiplexing spectroscopic device must be sometimes formed on a curved surface such as a lens surface depending upon the use purpose. In the case of the demultiplexing spectroscopic device formed on the flat surface, a rigid mother mold is formed, then a surface profile of this mother mold is transferred to a resin, and using the resulting resin mold, the demultiplexing spectroscopic device is formed. In the resin mold produced using the flat mother mold as above, the resin is not specifically restricted provided that it is transparent and has certain strength, and a usual resin has been used.

However, even if such a resin mold for a flat surface as above is intended to be applied to a curved surface, the resin mold does not fit the curved surface in many cases, and in order to completely fit the resin mold to the curved surface, a mother mold having the same shape as that of the curved surface must be produced. There are curved surface molds having various curvature radii or various shapes, and if amothermold is formed in accord with a specific curvature radius or shape, the mother mold becomes extremely expensive, and as a result, the resulting curved surface nanoimprint having a curved surface shape becomes extremely expensive.

As a nanoimprint resin mold, a mold consisting of a PET (polyethylene terephthalate) base and an acrylic resin laminated on the base is generally known (patent literature 1). To the mold described in the patent literature 1, however, a rigid layer formed from a material of high hardness is essential. Therefore, this mold hardly has stretchability, and imprinting can be made only on a substantially flat surface shape. On this account, it is necessary to prepare a mold that meets a mode in which a depression-protrusion profile of nanometer level is formed on a curved surface such as a lens surface.

In order to solve such a problem, an invention of "a curved surface member characterized in that a resin film having a depression-protrusion pattern formed thereon has been allowed to adhere to a curved surface" has been disclosed in a patent literature 2. In this patent literature 2, a curved surface body wherein a surface material composed of a thermoplastic resin having fine depressions and protrusions on the surface has been allowed to adhere to a curved surface has been disclosed.

In the curved surface body described in this patent literature 2, however, a thermoplastic resin having a depression-protrusion profile on its surface has been allowed to adhere to a surface of a lens or the like, and the thermoplastic resin is relatively rigid. Therefore, there is a problem that this curved surface body cannot be applied to a member (lens or the like) having a large curvature radius.

Citation List

Patent Literatures

Patent literature 1: Japanese Patent Laid-Open Publication No. 2008-068612
Patent literature 2: Japanese Patent Laid-Open Publication No. 2009-279831

Summary of Invention

Technical Problem

It is an object of the present invention to provide an imprint resin mold capable of imprinting even on a curved surface shape and a curved surface body obtained by using the mold.

Solution to Problem

The nanoimprint mold of the present invention is characterized by comprising a silicone rubber elastic body having an Hs rubber hardness of 10 to 55 and by having fine depressions and protrusions formed on the surface.

The silicone rubber elastic body for use in the present invention is ultraviolet curable silicone rubber or thermosetting silicone rubber.

The total light transmittance of the silicone rubber (measured using a sheet having a thickness of 250 $\mu$m in accordance with JIS K7105) is not less than 60%, preferably not less than 80%, and a higher transparency is preferable.

In the nanoimprint mold, the silicone rubber elastic body having an Hs rubber hardness of 10 to 55 can be used alone, but the silicone rubber elastic body can be formed on a surface of a transparent substrate.

The transparent substrate is preferably a curved surface body having a curved surface part having a curvature radius of not more than 500 mm.

The curved surface body of the present invention is preferably a curved surface body having a curved surface part having a curvature radius of not more than 500 mm, and having depressions and protrusions having an interval of 50 to 100000 nm on the surface of the curved surface part.

Advantageous Effects of Invention

According to the nanoimprint mold of the present invention, fine depressions and protrusions having been formed on a mother mold can be transferred from the mother mold to a surface of a silicone rubber elastic body having a specific hardness. Since this mother mold is formed from a rigid member such as silicone, glass or a metal and is extremely expensive, the depressions and protrusions of nano order are sometimes abraded or broken. On this account, the depressions and protrusions are transferred from the mother mold to a resin mold, and using this resin mold, a transfer plate having fine depressions and protrusions formed on its surface is produced. Most of such transfer plates are formed from a thermoplastic resin, so that when they are used as flat plates, any problem does not occur. However, in the case where depressions and protrusions are formed on a curved surface such as a lens surface, the morphological follow-up property becomes a problem. Moreover, the mold is a resin mold, and the resin is heated many times, and by the contact of such a resin with a thermoplastic resin, the depression-protrusion pattern having been formed on the surface of the resin mold is transferred to the thermoplastic resin. Therefore, the mold needs to also have high heat resistance.

Taking such usage into accounts, silicone rubber having an Hs rubber hardness of 10 to 55 is used in the present invention. By the use of such silicone rubber, stamping can be carried out repeatedly.

Brief Description of Drawings

[Fig. 1] Fig. 1 is a group of photographs each showing an example of a curved surface body of the present invention. Reference Example 1 attached is a photograph of this curved surface body, and the discolored part is an interference wave of a sheet having depressions and protrusions formed by the use of a nanoimprint mold.

[Fig. 2] Fig. 2 is a group of electron microscope photographs of depressions and protrusions formed on the sheet.

[Fig. 3] Fig. 3 is a group of sectional views of a mother mold 11 and a laminate 20 for forming depressions and protrusions by transferring fine depressions and protrusions from the mother mold 11 to silicone rubber 13 with a substrate 11.

[Fig. 4] Fig. 4 is a sectional view given when fine depressions and protrusions are transferred from the mother mold 11 to the silicone rubber 13 with a substrate 11.

[Fig. 5] Fig. 5 is a sectional view showing fine depressions and protrusions formed on the silicone rubber 13 with a substrate 11.

[Fig. 6] Fig. 6 is a sectional view showing an example of a state where the silicone rubber 13 has been allowed to adhere to a curved surface body.

Description of Embodiments

Next, the present invention is described in more detail with reference to the examples of the present invention, but it should be construed that the present invention is in no way limited to those examples.

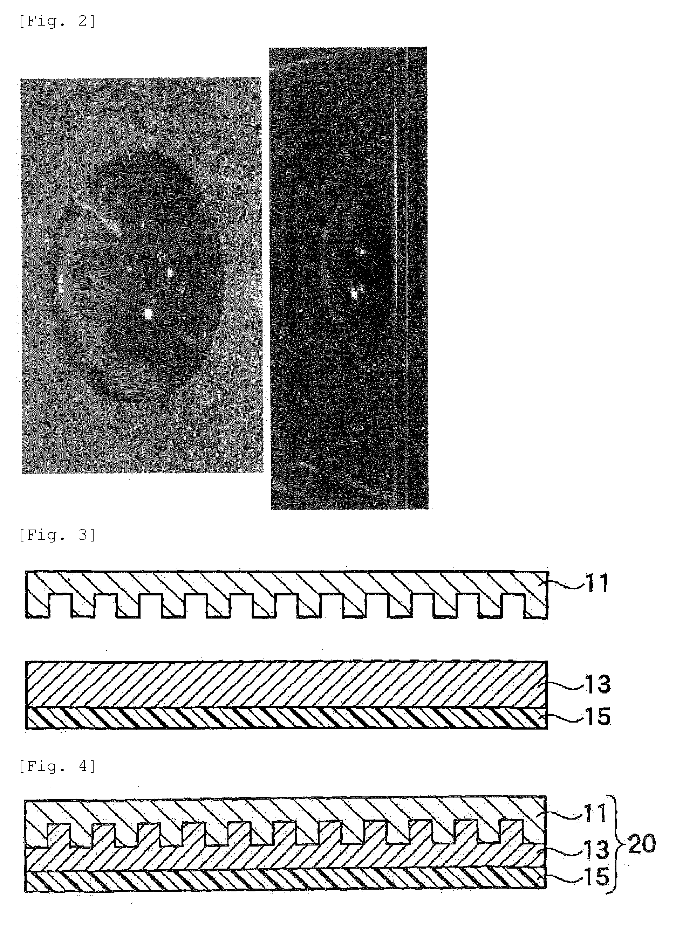

The nanoimprint mold of the present invention is obtained by bringing a silicone rubber elastic body having an Hs rubber hardness of 10 to 55, preferably 20 to 40, into contact with a mother mold having fine depressions and protrusions formed thereon and carrying out thermal imprinting or photo imprinting (see Fig. 3 to Fig. 5). In Fig. 3 to Fig. 5, reference numeral 11 designates a mother mold, and reference numeral 13 designates uncured silicone rubber. Reference numeral 15 designates a substrate, and the substrate is preferably used to support the uncured silicone rubber.

The mother mold 11 is not specifically restricted provided that it is a publicly known nanoimprint mold. The mother mold may be a mold prepared from silicone, glass, a metal or the like, or may be such a replica mold as described in Japanese Patent Laid-Open Publication No. 2011-25677.

The resin used for the substrate 15 is not specifically restricted, but in order to photo-cure the silicone rubber, a light transmitting resin is preferably used, and it is preferable to use polycarbonate (PC), polyethylene terephthalate (PET), polymethyl methacrylate (PMMA) or the like. Since the mold is used after this substrate 15 is peeled off, at least a surface of the substrate on which a silicone rubber layer is to be provided is preferably subj ected to release treatment.

On the surface of such a substrate 15, an uncured silicone rubber layer 13 is formed.

This silicone rubber layer 13 comprises a mixture of tetrafunctional, trifunctional, bifunctional or monofunctional organosiloxane and a catalyst, and the mixture is cured by means of light (ultraviolet light) or heat to form a ladder polymer, whereby silicone rubber having a specific Hs rubber hardness is formed. Especially in the present invention, it is preferable to adjust the type of the organosiloxane so that the silicone rubber, which is obtained by bringing the mixture into contact with the mother mold and subj ecting it to thermal imprinting or photo imprinting to transfer the depression-protrusion profile having been formed on the surface of the mother mold, as shown in Fig. 4, may have an Hs rubber hardness of 10 to 55, preferably 20 to 40. Before and after the curing, the thickness of the silicone rubber layer is 50 to 5000 $\mu$m, preferably 100 to 1000 $\mu$m. On the silicone rubber layer, a release layer can be further laminated.

The Hs rubber hardness in the present invention is a hardness derived from the following formula.

[Math. 1]

$$\mathrm{Hs \ rubber \ hardness \ = \ G \div (G + G_{50}) \times 100}$$

In this formula, G is a modulus of transverse elasticity (Pa) of the silicone elastic body after cured by heat or light, and $G_{50}$ is a rubber constant of a rubber having a hardness of 50, and in the present invention, the rubber constant is $7.45 \times 10^5 \div 1.0197$ (Pa) obtained based on the description of "Sesshoku ni yoru ouryoku no shuchu to gensui (concentration and decay of stress due to contact)" (Mech D&A News Letter, Vol. 1997-1, Mechanical Design Co., Ltd.). A specific method to measure the modulus of transverse elasticity is described later in the working examples.

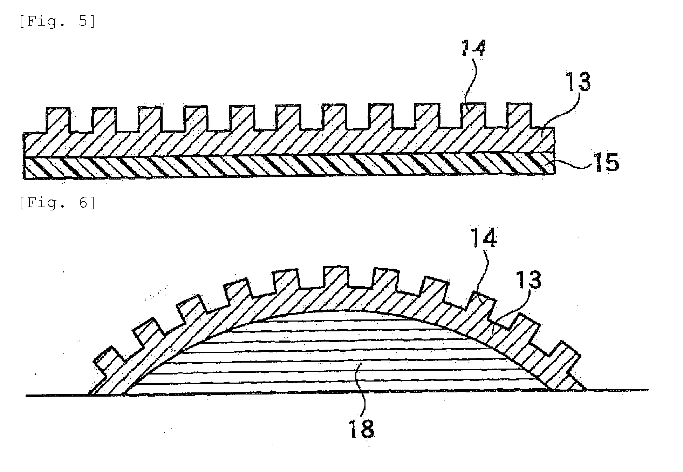

In Fig. 5, a pattern 14 that is reverse to the pattern formed on the mother mold 11 is formed on the surface of the silicon rubber layer having been cured by irradiating the silicone rubber layer with light.

By allowing this reverse pattern 14 to adhere to a curved surface body such as a lens, preferably a curved surface body having a curved surface part having a curvature radius of not more than 500 mm, a nanoimprint mold of the present invention can be formed.

The nanoimprint mold of the present invention thus formed is preferably used for imprinting on a thermoplastic resin or a thermosetting resin. As the transfer material imprinted, not only such a conventional flat body (film) as nanoimprinted but also a fine curved surface body which has a curved surface part having a curvature radius of not more than 500 mm and has depressions and protrusions having an interval of 50 to 200000 nm, preferably 100 to 100000 nm, on the surface of the curved surface part can be prepared, because the nanoimprint mold of the present invention has proper morphological follow-up property and hardness. In the case where imprinting is made on a curved surface body, it is preferable to narrow the interval between protrusions of the depressions and protrusions formed on the surface of the mold more and more toward the peripheral part from the central part, according to the Hs rubber hardness of the silicone rubber elastic body, because the nanoimprint mold of the present invention extends.

The silicone rubber for use in the present invention has good morphological follow-up property to a curved surface and can be brought into close contact with a curved surface of a curved surface body without any gap, because the Hs rubber hardness is in the above range.

Examples

Next, the nanoimprint mold and the curved surface body of the present invention are further described with reference to the following examples, but it should be construed that the present invention is in no way limited to those examples.

Various properties of the nanoimprint mold of the present invention can be measured by the use of the following apparatuses.

[Sample]

Four kinds of sheets composed of uncured silicone rubber and having a thickness of 250 $\mu$m were prepared, and modulus of transverse elasticity and total light transmittance were measured in the following manner. Sample (rubber hardness : sample thickness)

(Modulus of transverse elasticity)

Using a rheometer (manufactured by Anton Paar, name of apparatus: PHYSICA MCR300), modulus of transverse elasticity was measured under the following conditions.

Temperature control apparatus: TC30/CTD600
Measuring fixture: PP8
Number of points of measurement: 10 points
Measuring interval: 10 sec
Measuring time: 100 sec
Measurement mode: rotation
Strain (y): 0→0.1 (Linear)
Normal force: 10 N
Temperature: 23°C
(Total light transmittance)

Using a haze meter (manufactured by Murakami Color Research Laboratory Co., Ltd., type: HM-150), total light transmittance was measured in accordance with JIS K7105.

[Table 1]

Table 1

| Silicone rubber | Modulus of transverse elasticity | Hs rubber hardness | Total light transmittance |
|---|---|---|---|
| KE-103 | 240000 Pa | 26 | 88% |
| KE-106 | 730000 Pa | 52 | 88% |
| SIM-260 | 110000 Pa | 62 | 88% |
| KE-1204 | 140000 Pa | 67 | 20% |
| * The silicone rubbers are each manufactured by Shin-Etsu silicone Co., Ltd. | | | |

[Preparation of mold]

[Example 1]

•Preparation of silicone rubber mold

A glass substrate was coated with uncured silicone rubber (KE-103) by spin coating (rotation speed: 500 rpm, time: 20 sec) to prepare a resin layer. Against the laminate of the substrate and the resin layer, a master mold (quartz mold having been subjected to mold release treatment, transfer surface: 30 mm square, 150 nm L&S) was pressed, and a deposit of the resin layer was heated to 140°C to perform thermal curing transfer. During the thermal curing transfer, the pressing pressure was 1 MPa, and the holding time was 20 minutes. Thereafter, cooling was carried out, and the master mold was removed to obtain a silicone rubber mold having a thickness of 100 $\mu$m.

•Transfer to curved surface

On a surface of a curved surface lens having a curvature radius of 40 mm, a proper amount of an UV curable resin was dropped, and the silicone mold was pressed against the above lens surface so that the liquid dropped might spread over the whole surface, and the silicone mold was fixed thereto. Then, UV irradiation was carried out through the silicone mold to cure the UV curable resin, whereby the same profile as that of the master mold was transferred to the whole surface of the lens.

[Example 2]

•Preparation of silicone rubber mold

A film master mold and uncured KE-103 were interposed between two glass substrates. When the uncured KE-103 spread over the whole surface of the film master mold, the glass substrates were fixed so as not to shift, and in such a fixed state, they were allowed to stand still in a drier having been adjusted to 150°C to cure the KE-103, whereby a silicone mold having a thickness of 1 mm was obtained.

Transfer was carried out under the same conditions as in Example 1 to obtain a lens, to the whole surface of which the same profile as that of the master mold had been transferred.

[Example 3]

Using KE-106, a silicone mold was prepared in the same manner as in Example 2. Thus, a silicone mold having a thickness of 1 mm was obtained. Thereafter, transfer was carried out under the same conditions as those for the transfer to curved surface in Example 1, whereby a lens, to the whole surface of which the same profile as that of the master mold had been transferred, was obtained.

[Comparative Example 1]

Using SIM-260, a silicone mold was prepared in the same manner as in Example 2. Thus, a silicone mold having a thickness of 1 mm was obtained. Thereafter, transfer was carried out under the same conditions as those for the transfer to curved surface in Example 1. However, it was difficult to follow up the whole surface of the lens, and to the edges of the curved surface lens, the same profile as that of the master mold could not be transferred.

[Comparative Example 2]

Using KE-1204, a silicone mold was prepared in the same manner as in Example 2. Thus, a silicone mold having a thickness of 1 mm was obtained. Thereafter, transfer was carried out under the same conditions as those for the transfer to curved surface in Example 1. However, it was difficult to follow up the whole surface of the lens, and moreover, it was difficult to cure the UV curable resin because of low transparency.

[Table 2]

Table 2

| | | Silicone rubber | Thickness | Curvature radius | Results of transfer |
|---|---|---|---|---|---|
| | Ex. 1 | KE-103 | 100 $\mu$m | 40 | ○ |
| | Ex. 2 | KE-103 | 1 mm | 40 | ○ |
| | Ex. 3 | KE-106 | 1 mm | 40 | ○ |
| | Comp. Ex. 1 | SIM-260 | 1 mm | 40 | Δ |
| | Comp. Ex. 2 | KE-1204 | 1 mm | 40 | × |

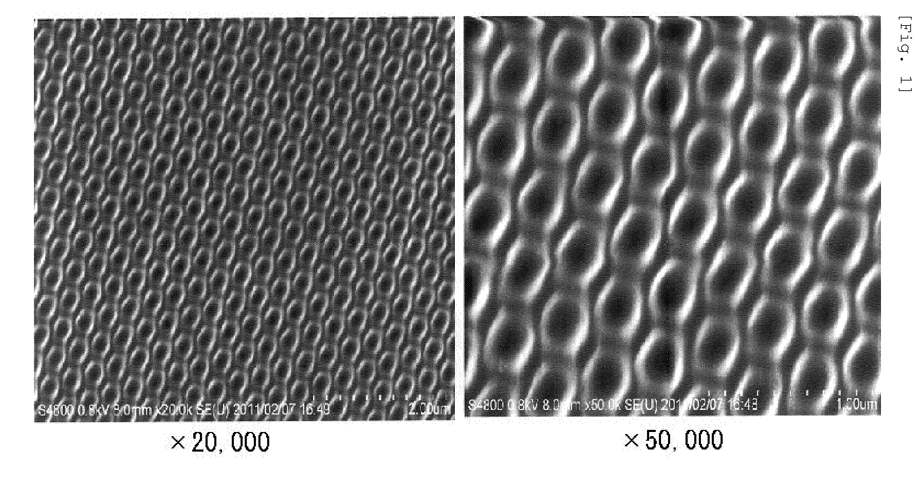

The nanoimprint molds obtained as above were each allowed to adhere to a surface of a spherical lens shown in Fig. 1 to produce curved surface bodies.

Reference Numerals List

11: mother mold
13: thermoplastic resin
14: depressions and protrusions
15: substrate
18: curved surface body
20: laminate for forming depressions and protrusions

**Claims**

1.  A nanoimprint mold comprising a silicone rubber elastic body having an Hs rubber hardness of 10 to 55, and having fine depressions and protrusions formed on the surface.

2.  The nanoimprint mold as claimed in claim 1, wherein the silicone rubber elastic body is ultraviolet curable silicone rubber or thermosetting silicone rubber.

3.  The nanoimprint mold as claimed in claim 1, wherein the total light transmittance of the silicone rubber (measured using a sheet having a thickness of 250 $\mu$m in accordance with JIS K7105) is not less than 60%.

4.  The nanoimprint mold as claimed in claim 1, wherein the silicone rubber elastic body is formed on a surface of a transparent substrate.

5.  The nanoimprint mold as claimed in claim 4, wherein the transparent substrate is a curved surface body having a curved surface part having a curvature radius of not more than 500 mm.

6.  A curved surface body having a curved surface part having a curvature radius of not more than 500 mm, and having depressions and protrusions having an interval of 50 to 100000 nm on the surface of the curved surface part.

7.  The curved surface body as claimed in claim 6, which is obtained by using the nanoimprint mold as claimed in any one of claims 1 to 5.

[Fig. 1]

×50,000

×20,000

[Fig. 2]

[Fig. 3]

[Fig. 4]

[Fig. 5]

[Fig. 6]

## INTERNATIONAL SEARCH REPORT

International application No.

PCT/JP2012/062391

| A. CLASSIFICATION OF SUBJECT MATTER |
|---|
| B29C59/02(2006.01)i, B29C33/40(2006.01)i, H01L21/027(2006.01)i |

According to International Patent Classification (IPC) or to both national classification and IPC

| B. FIELDS SEARCHED |
|---|

Minimum documentation searched (classification system followed by classification symbols)
B29C59/02, B29C33/40, H01L21/027

Documentation searched other than minimum documentation to the extent that such documents are included in the fields searched

| Jitsuyo Shinan Koho | 1922–1996 | Jitsuyo Shinan Toroku Koho | 1996–2012 |
| Kokai Jitsuyo Shinan Koho | 1971–2012 | Toroku Jitsuyo Shinan Koho | 1994–2012 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X<br>Y | JP 2010-005899 A (Dainippon Printing Co., Ltd.),<br>14 January 2010 (14.01.2010),<br>entire text; particularly, paragraphs [0009], [0030]<br>(Family: none) | 1-4<br>5-7 |
| X<br>Y | JP 2010-120316 A (Ricoh Co., Ltd.),<br>03 June 2010 (03.06.2010),<br>claims; paragraphs [0051] to [0061]; fig. 6 to 11<br>(Family: none) | 6,7<br>1-3,5 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>29 June, 2012 (29.06.12) | Date of mailing of the international search report<br>10 July, 2012 (10.07.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2012/062391 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2010-080865 A  (Dainippon Printing Co., Ltd.), 08 April 2010 (08.04.2010), entire text; particularly, paragraph [0047] (Family: none) | 1-7 |
| A | JP 2011-005768 A  (Dainippon Printing Co., Ltd.), 13 January 2011 (13.01.2011), entire text; particularly, paragraph [0039] (Family: none) | 1-7 |
| A | JP 60-145846 A  (Toppan Printing Co., Ltd.), 01 August 1985 (01.08.1985), entire text; particularly, examples (Family: none) | 1-7 |
| A | JP 61-089380 A  (Kyowa Leather Cloth Co., Ltd.), 07 May 1986 (07.05.1986), entire text; particularly, example 3 (Family: none) | 1-7 |

Form PCT/ISA/210 (continuation of second sheet) (July 2009)

## INTERNATIONAL SEARCH REPORT

International application No.

PCT/JP2012/062391

| Box No. II | Observations where certain claims were found unsearchable (Continuation of item 2 of first sheet) |
| --- | --- |

This international search report has not been established in respect of certain claims under Article 17(2)(a) for the following reasons:

1. ☐ Claims Nos.:

because they relate to subject matter not required to be searched by this Authority, namely:

2. ☐ Claims Nos.:

because they relate to parts of the international application that do not comply with the prescribed requirements to such an extent that no meaningful international search can be carried out, specifically:

3. ☐ Claims Nos.:

because they are dependent claims and are not drafted in accordance with the second and third sentences of Rule 6.4(a).

| Box No. III | Observations where unity of invention is lacking (Continuation of item 3 of first sheet) |
| --- | --- |

This International Searching Authority found multiple inventions in this international application, as follows:

Although it is considered that the inventions of claims 1-5 have a common matter which is relevant to the invention of claim 1 and the invention of claim 7 relate to a curved surface body using a mold according to the inventions of claims 1-5, the invention of claim 1 and the invention of claim 6 are common to each other in only the point such that both the inventions "have fine recess and protrusion".

Further, the above-said common matter is not a special technical feature, since the invention of claim 1 is disclosed in the document 1 which is cited in this international search report.

(Continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

| INTERNATIONAL SEARCH REPORT | International application No. |
|---|---|
| | PCT/JP2012/062391 |

Continuation of Box No.III of continuation of first sheet(2)

Consequently, it is obvious that this international application involves two or more inventions.

## REFERENCES CITED IN THE DESCRIPTION

**Patent documents cited in the description**

- JP 2008068612 A
- JP 2009279831 A

- JP 2011025677 A

**Non-patent literature cited in the description**

- Mech D&A News Letter. Mechanical Design Co., Ltd, January 1997